# EUROPÄISCHE PATENTSCHRIFT

(11) **EP 1 564 848 B1**
(45) Veröffentlichungstag und Bekanntmachung des Hinweises auf die Patenterteilung: **16.10.2013**
(21) Anmeldenummer: 05100592.4
(22) Anmeldetag: 28.01.2005
(51) Int. Cl.: H01R 13/64, H01R 9/26

(54) **Installationsgerät mit kodierbarer Steckschnittstelle und entsprechendes Zusatzmodul**
Installation device with codable plug-in interface and corresponding additional module
Dispositif d'installation avec interface enfichable codable et module supplémentaire correspondant

(30) Priorität: 16.02.2004 DE 102004007423
(43) Veröffentlichungstag der Anmeldung: 17.08.2005
(73) Patentinhaber: Siemens Aktiengesellschaft, 80333 München (DE)
(72) Erfinder: Busch, Klaus, 92224, Amberg (DE)

(56) Entgegenhaltungen:
- EP-A1- 0 774 768
- WO-A-02/086929
- WO-A-2004/068645
- WO-A-2004/068662
- DE-A1- 19 650 988
- DE-U- 7 138 560
- US-A- 5 697 806
- US-B1- 6 392 319

## Beschreibung

Die vorliegende Erfindung betrifft ein Zusatzmodul zum Anbringen an das Installationsgerät mit einer Geräteschnittstelle einschließlich einer Befestigungseinrichtung, mit der das Zusatzmodul an das Installationsgerät befestigbar ist, und einer Modulschnittstelle einschließlich einer Modulbefestigungseinrichtung, mit der ein weiteres Zusatzmodul an das vorliegende Zusatzmodul befestigbar ist.

Aus der Druckschrift EP 1 126 568 ist bekannt, an Installationsgeräte Module anzustecken. Dies dient dazu, Anlagen rascherer und sicherer montieren zu können.

Darüber hinaus ist intern bekannt, Anschlussmodule, an denen Leitungen mittels Schraub-, Federzug- oder Schneidklemmtechnik befestigbar sind, an Installationsgeräte anzustecken. Dabei werden zapfenförmige Kodiermittel am Installationsgerät und entsprechende Gegenkodiermittel am Anschlussmodul verwendet, um eine modulplatzspezifische Zuordnung zu gewährleisten. Zur Befestigung sind Rastmittel an den entsprechenden Modulplätzen und Gegenrastmittel an den Anschlussmodulen vorgesehen.

Die DE 196 50 988 A1 betrifft elektrische Reihenklemmen, wobei an die Stirnflächen der Reihenklemmen zusätzliche Klemmen angedockt sind, die automatisch einen Andock-Stirnkontakt der Reihenklemme kontaktieren, der seinerseits über eine klemmeninterne Leitung mit der eingebauten oder aufgesteckten Elektronik verbunden ist.

Aus der US 6 392 319 B1 ist eine modular aufgebaute elektrische Vorrichtung bekannt, bei der die einzelnen Module auf einer Hutschiene angeordnet sind und elektrisch miteinander verbunden werden können.

Des Weiteren ist aus der US 5 697 806 A ein elektrisches Kontaktelement bekannt, das mit einer elektrischen Leitung verbunden ist und das mit einem elektrischen Kontaktelement identischer Bauart verbunden werden kann.

Überdies ist aus der EP 0 774 768 A1 ein modulares Steuerungssystem für einen Schütz bekannt, bei dem verschiedene Module mit Verrasthaken aneinander befestigt werden können.

Aus der WO 2004/068662 A1 und der WO 2004/068645 A1, die nach dem Anmeldetag der vorliegenden Anmeldung veröffentlicht wurden, ist ein Installationsgerät bekannt, an dem Anschlussmodule angeordnet werden können. Für jedes Anschlussmodul sind entsprechende Kodiermittel in Form von Aussparungen für eine modulplatzspezifische Zuordnung vorgesehen. Die Gegenkodiermittel an den Anschlussmodulen sind als Winkelelemente ausgebildet.

Angesichts einer hohen Vielzahl von Kombinationsmöglichkeiten von am Installationsgerät vorhandenen Modulsteckplätzen mit unterschiedlichen Modultypen sind Kodiermittel an den Installationsgeräten und anzuschließenden Zusatzmodulen unumgänglich. Gleichzeitig besteht aber auch der Bedarf, die Konturen der anzuschließenden Module bzw. der Modulsteckplätze möglichst einfach zu gestalten, um einfache Steckbewegungen zu ermöglichen.

Die Aufgabe der vorliegenden Erfindung besteht somit darin, ein Zusatzmodul zum Anbringen an ein Installationsgerät vorzuschlagen, das an einem Modulplatz oder mehreren Modulplätzen verwechslungsfrei bei einfach ausgebildeten Konturen angebracht werden kann.

Erfindungsgemäß wird diese Aufgabe gelöst durch ein Zusatzmodul zum Anbringen an ein Installationsgerät mit einer Geräteschnittstelle einschließlich einer Befestigungseinrichtung, mit der das Zusatzmodul an das Installationsgerät befestigbar ist, und ersten Kodiermitteln, die an der Geräteschnittstelle angeordnet sind, so dass das Zusatzmodul nur dann an das Installationsgerät anbringbar ist, wenn das Installationsgerät entsprechende Gegenkodiermittel aufweist, wobei die ersten Kodiermittel Teil der Befestigungseinrichtung sind und einer Modulschnittstelle einschließlich einer Modulbefestigungseinrichtung, mit der ein weiteres Zusatzmodul an das vorliegende Zusatzmodul befestigbar ist, und Modulkodiermittel, die an der Modulschnittstelle angeordnet sind, besitzt, so dass das weitere Zusatzmodul an dem vorliegenden Zusatzmodul nur dann anbringbar ist, wenn das weitere Zusatzmodul entsprechende Modulgegenkodiermittel aufweist, wobei die Befestigungseinrichtung mindestens einen, im Querschnitt L-förmigen Vorsprung aufweist, so dass das Zusatzmodul durch zwei zueinander orthogonale Bewegungsvorgänge an dem Installationsgerät befestigbar ist, wobei entsprechend des ersten der Bewegungsvorgänge eine erste Fixierung erfolgt und über den zweiten der Bewegungsvorgänge das Zusatzmodul in eine Endlage gebracht ist, die Modulbefestigungseinrichtung mindestens eine L-förmige Aussparung aufweist, so dass das weitere Zusatzmodul durch zwei zueinander orthogonale Bewegungsvorgänge an dem vorliegenden Zusatzmodul befestigbar ist, wobei entsprechend des ersten der Bewegungsvorgänge eine erste Fixierung erfolgt und über den zweiten der Bewegungsvorgänge das weitere Zusatzmodul in eine Endlage gebracht ist.

Erfindungsgemäß weist die Befestigungseinrichtung des Installationsgeräts eine L-förmigen Aussparung auf, so dass das Zusatzmodul, das einen L-förmigen, zur L-Form der Aussparung orthogonalen Vorsprung besitzt, durch zwei zueinander orthogonale Bewegungsvorgänge an dem Installationsgerät befestigbar ist. Dabei ist es besonders vorteilhaft, wenn eine Abmessung oder Position der L-förmigen Aussparung in Abhängigkeit von der Kodierung der ersten Kodiermittel gewählt ist. Auf diese Weise kann ein sehr einfach zu gestaltendes Befestigungs- und Kodiermittel realisiert werden, und es müssen nicht zusätzlich zu den Befestigungsmitteln Aussparungen oder Vorsprünge zur Kodierung am Installationsgerät bzw. Zusatzmodul vorgesehen werden. Damit ist ein Beitrag zur Vereinfachung der Kontur des Installationsgeräts und Zusatzmoduls geleistet.

In der gleichen Technik wie das Zusatzmodul auf das Installationsgerät gesteckt wird, kann ein weiteres Zusatzmodul auf das vorliegende Zusatzmodul aufgebracht werden. Hierzu besitzt das vorliegende Zusatzmodul eine Modulschnittstelle einschließlich einer Modulbefestigungseinrichtung, mit der das weitere Zusatzmodul an das vorliegende Zusatzmodul befestigbar ist, und Modulkodiermittel, die an der Modulschnittstelle angeordnet sind, so dass das weitere Zusatzmodul an dem vorliegenden Zusatzmodul nur dann anbringbar ist, wenn das weitere Zusatzmodul entsprechend dem Modul Gegenkodiermittel aufweist. Besonders vorteilhaft dabei ist, wenn wiederum die Modulkodiermittel Teil der Modulbefestigungseinrichtung sind. Somit können auch auf Zusatzmodul weitere Zusatzmodule einfach und verwechslungsfrei aufgebracht bzw. aufgesteckt werden.

Erfindungsgemäß kann somit eine Schnittstelle an Installationsgeräten für Anschlussmodule mit verschiedenen Anschlusstechnologien unter Berücksichtigung der Anbindung an übergeordnete Steuerungen durch Ansteuermodule vorteilhaft realisiert werden. Des Weiteren ist es möglich, die Anschlussmodule und die Ansteuermodule verwechslungsfrei an den Installationsgeräten zu befestigen. Insbesondere ist es möglich, an einem Kompaktabzweig, der ein Installationsgerät darstellt, ein Anschlussmodul bzw. eine abnehmbare Klemme und/oder ein Ansteuermodul für eine Anbindung an eine übergeordnete Steuerung anzukoppeln. Die Verbindung von Befestigungs- und Kodiermitteln bringt dabei eine deutliche Vereinfachung der Modulschnittstelle des Installationsgeräts bzw. des anzubringenden Moduls.

Vorzugsweise weist das Zusatzmodul eine Verriegelungseinrichtung zum Verriegeln des Zusatzmoduls an dem Installationsgerät auf. Speziell kann die Verriegelungseinrichtung einen Verrasthaken aufweisen. Damit ist es möglich, die Verriegelung von Anschlussmodulen und Ansteuermodulen zu den Installationsgeräten gegen unbeabsichtigtes Lösen mit geringem Platzbedarf zu gewährleisten.

Das Installationsgerät kann ferner mehrere der genannten Modulschnittstellen aufweisen. Damit können nicht nur mehrere Ansteuermodule an das Installationsgerät angekoppelt werden, sondern es besteht auch die Möglichkeit, die Ansteuermodule an einer Seite des Installationsgeräts vorzusehen und die Anschlussmodule an einer anderen Seite.

Vorteilhafterweise sind an der Modulschnittstelle zweite, von den ersten Kodiermitteln unabhängige Kodiermittel zum Zusammenwirken mit entsprechenden zweiten Gegenkodiermitteln an dem anzubringenden weiteren Zusatzmodul angeordnet. Dabei können die zweiten Kodiermittel mindestens einen Zapfen oder mindestens eine entsprechende Aussparung an einem vorgegebenen Ort an der Modulschnittstelle umfassen. Dies bedeutet, dass unterschiedliche Kodiermittel, mit und ohne Befestigungs- oder Führungsfunktion, miteinander beliebig kombiniert werden können.

Wie bereits erwähnt, kann das Zusatzmodul als Anschlussmodul oder Ansteuermodul ausgebildet sein. Zur Zusammenschaltung mehrerer Installationsgeräte kann das Ansteuermodul dann insbesondere als Startmodul oder Erweiterungsmodul realisiert werden.

Die vorliegende Erfindung wird nun anhand der beigefügten Zeichnungen näher erläutert, in denen zeigen:
- FIG 1: ein Schaltungsdiagramm einer Anbindung von Installationsgeräten an ein SPS-System;
- FIG 2: eine perspektivische Ansicht eines Installationsgeräts mit aufgesteckten Anschlussmodulen;
- FIG 3: ein Installationsgerät mit aufgesteckten und abgesteckten Anschlussmodulen;
- FIG 4: eine Detailansicht der Kodier- bzw. Befestigungsmittel von FIG 3;
- FIG 5: eine Ansicht des Installationsgeräts von FIG 3 mit Ausschnitten zur Erläuterung einer ersten Kodiervariante;
- FIG 6: ein Installationsgerät gemäß FIG 3 mit Ausschnitten zur Erläuterung einer zweiten Kodiervariante;
- FIG 7: eine perspektivische Ansicht zweier kombinierter Installationsgeräte mit mehreren aufgesteckten Modulen;
- FIG 8: die beiden Installationsgeräte von FIG 7 mit abgenommenen Modulen;
- FIG 9: eine Detailansicht der Module von FIG 7, wobei das auf das Startmodul aufzusteckende Anschlussmodul abgenommen ist.

Die nachfolgend näher dargestellten Ausführungsbeispiele stellen bevorzugte Ausführungsformen der vorliegenden Erfindung dar.

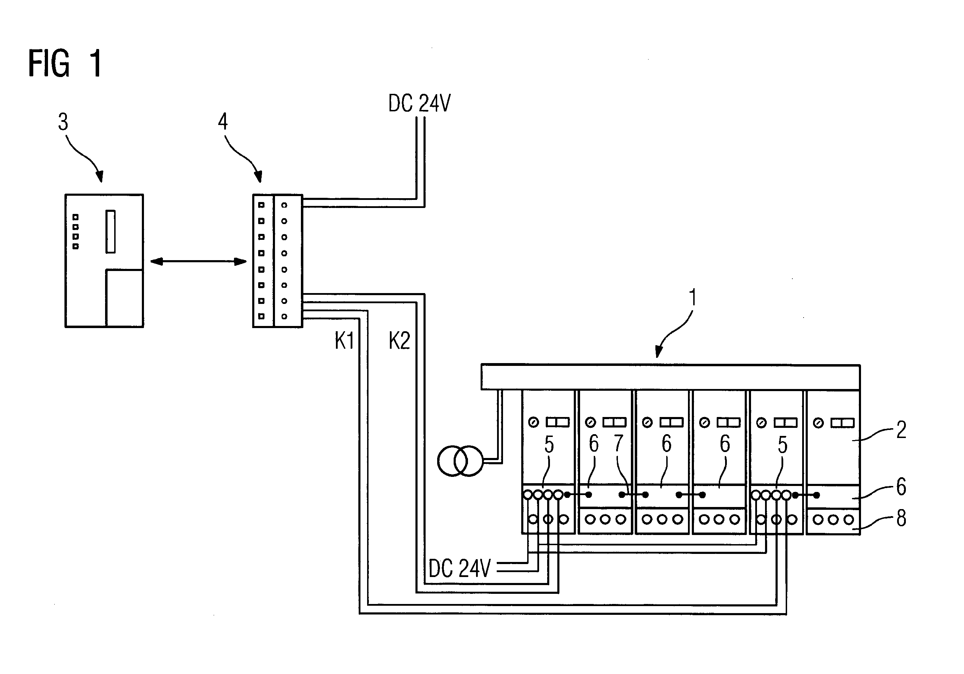

FIG 1 zeigt ein Energieverteilungssystem 1, an das mehrere Installationsgeräte 2 angeschlossen sind. Die Anbindung der Installationsgeräte 2 an eine übergeordnete Steuerung (SPS) 3 erfolgt über ein System mit Standard-Ein- und Ausgabebaugruppen 4. Über einen Ansteuerkanal K1 oder K2 werden jeweils ein oder mehrere Installationsgeräte über aufgesteckte Ansteuermodule angesteuert bzw. die Schaltzustände der Installationsgeräte 2 an die übergeordnete Steuerung 3 zurückgemeldet.

Die Ansteuermodule, die als Startmodule 5 oder Erweiterungsmodule 6 realisiert sein können, beinhalten für die Datenübertragung jeweils eine elektronische Einheit. Mit Verbindungssteckern 7 können die Ansteuermodule 5, 6 miteinander verbunden werden. Die Startmodule 5 benötigen Klemmen für beispielsweise eine Spannungsversorgung und den Ansteuer- bzw. Rückmeldekanal K1 oder K2. Da die Versorgungsspannung und die Ansteuersignale über einen Verbindungsstecker 7 vom Startmodul 5 zum ersten Erweiterungsmodul 6 bzw. zwischen den weiteren Erweiterungsmodulen 6 weitergeleitet werden, sind bei den Erweiterungsmodulen 6 in dieser Ausprägung keine Klemmen notwendig.

Für diverse anzuschließende Leitungen ist im vorliegenden Beispiel jedes Installationsgerät zusätzlich mit einem Anschlussmodul 8 bestückt. Der Übersicht halber sind jedoch Anschlussleitungen, die in den Anschlussmodulen münden, in FIG 1 nicht eingezeichnet.

Für eine schnelle und sichere Montage bzw. Demontage der Ansteuermodule 5, 6 an den Installationsgeräten 2 ist die nachfolgend beschriebene Montagetechnik vorgeschlagen, mit der die Module verwechslungsfrei aufgesteckt und durch platzsparende Verriegelungseinrichtungen gegen unbeabsichtigtes Lösen am Installationsgerät 2 verriegelt werden können.

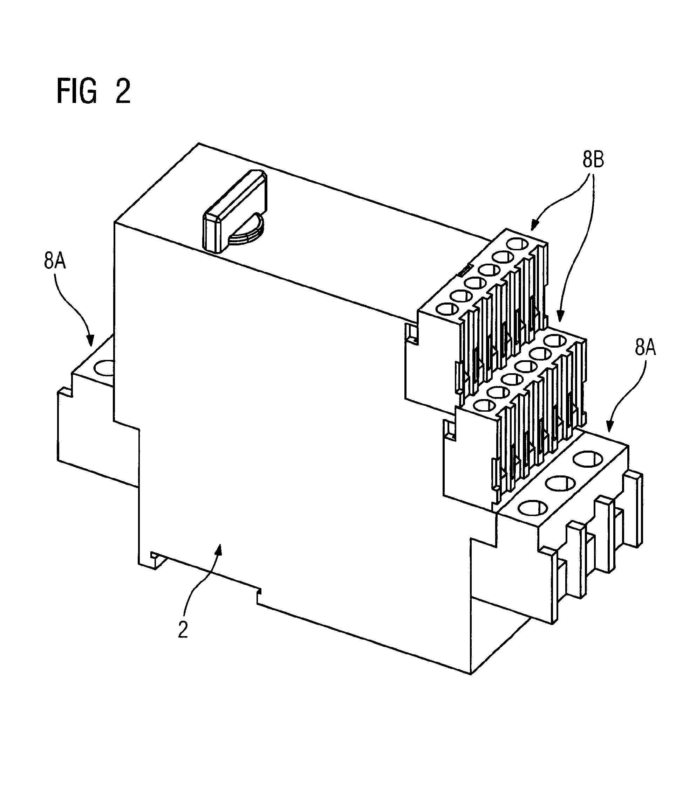

In FIG 2 ist ein Motorstarter, ein typisches Installationsgerät 2, perspektivisch dargestellt. Insgesamt sind vier Anschlussmodule 8 an dem Installationsgerät 2 montiert. Üblicherweise erfolgen die Leistungsanschlüsse 8A über ein Anschlussmodul je Seite des Installationsgeräts und die Ansteueranschlüsse über Anschlussmodule 8B vorteilhaft auf einer Seite des Installationsgeräts 2, wie dies auch in FIG 2 wiedergegeben ist.

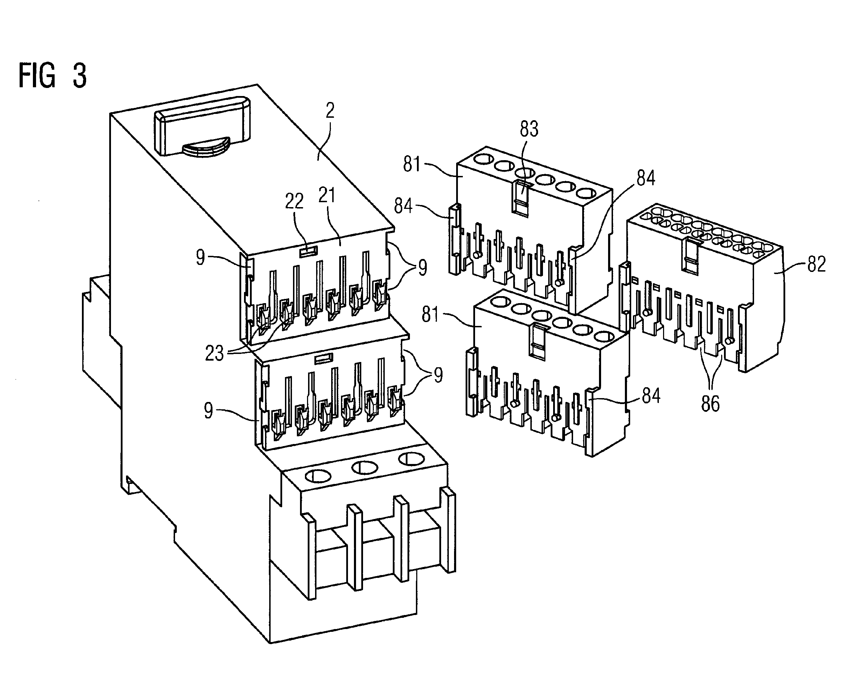

In FIG 3 sind zur Darlegung der konstruktiven Ausprägung der Schnittstelle zwischen dem Installationsgerät 2 und dem jeweiligen Anschlussmodul zwei der Anschlussmodule 81 vom Installationsgerät 2 abgenommen und gedreht in einer Explosionsdarstellung wiedergegeben. Ergänzend ist ein drittes Anschlussmodul 82 dargestellt. Die Anschlussmodule können grundsätzlich in beliebigen Anschlusstechnologien ausgeführt sein. In dem Beispiel von FIG 3 sind die zwei Anschlussmodule 81 in der Ausführung in Schraubtechnik und das Anschlussmodul 82 in der Ausführung in Federzugtechnik dargestellt. In bekannter Weise sind in die Anschlussmodule 81 Anschlussdrähte einzuschrauben. Demgegenüber sind in das Anschlussmodul 82, das in Federzugtechnik ausgeführt ist, Drahtanschlüsse in ebenfalls bekannter Weise einzuklemmen. Die Befestigung der Module an den Installationsgeräten ist jedoch unabhängig von der verwendeten Anschlusstechnologie.

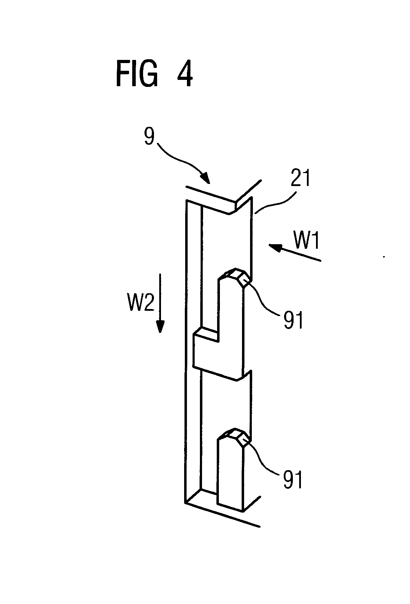

Wie aus FIG 3 ebenfalls ersichtlich ist, besitzt das Installationsgerät 2 an seinen seitlichen Begrenzungswänden L- bzw. winkelförmige Aussparungen 9. Eine derartige Aussparung 9 ist in FIG 4 vergrößert dargestellt. Die Aussparungen 9 führen bei der Montage eines Anschlussmoduls 8 eine erste geometrische Fixierung zum Installationsgerät 2 herbei. Diese erste Fixierung erfolgt entsprechend einer ersten Bewegung W1, deren Richtung in FIG 4 mit einem Pfeil dargestellt ist, und mit der das zu fixierende Modul an das Installationsgerät 2 bzw. in die Aussparung 9 geführt wird. Unterstützt wird diese Fixierung durch Phasen oder Rundungen 91 an den Aussparungen 9.

Über eine zweite Bewegung W2, deren Richtung in FIG 4 ebenfalls mit einem Pfeil eingezeichnet ist, wird das Anschlussmodul entlang der stirnseitigen Führungswand 21 des Installationsgeräts in seine Endlage gebracht. In dieser Endlage verrastet ein Verrasthaken 83 in einer Ausnehmung 22 an der Stirnseite des Installationsgeräts 2 (vgl. FIG 3). Mit einem Standardwerkzeug, z. B. einen Schraubendreher, kann der Verriegelungs- bzw. Verrasthaken aus seiner Arretierung in der Ausnehmung 22 gebracht werden. Durch dem Fügevorgang entgegengesetzte Bewegungen kann das Anschlussmodul von dem Installationsgerät 2 dann wieder demontiert werden.

Die elektrischen Verbindungen an den jeweiligen Modulschnittstellen werden über Kontakte 23 hergestellt. Diese ragen im vorliegenden Beispiel am Installationsgerät 2 nach außen und greifen in Aussparungen 86 mit entsprechenden Gegenkontakten im Anschlussmodul.

Zur Befestigung in den winkelförmigen Aussparungen 9 besitzt jedes Modul an beiden Seiten entsprechende klammerartige Vorsprünge 84. Diese besitzen in Teilabschnitten in einem Querschnitt senkrecht zu der Bewegungsrichtung W2 eine L-förmige Gestalt. Im montierten Zustand greift dann der vom Modul abgewandte Schenkel des L-förmigen Vorsprungs 84 in die Aussparung 9 des Installationsgeräts.

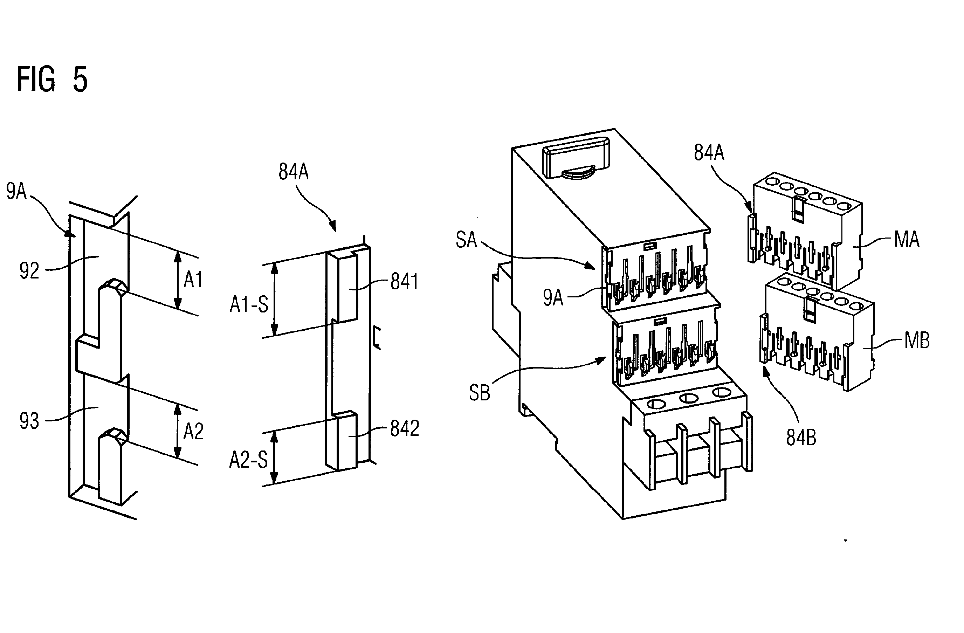

Eine differenzierte Zuordnung von Anschlussmodulen zu verschiedenen Steckplätzen, beispielsweise den in FIG 5 gekennzeichneten Steckplätzen SA und SB, an dem Installationsgerät 2 kann über entsprechende Kodierung erfolgen. Die winkelförmigen Aussparungen 9 am Installationsgerät 2 und ebenso die klammerartigen Vorsprünge 84 an den Anschlussmodulen sind hierfür in verschiedenen, geometrischen Abmessungen ausgeführt. Dementsprechend ist eine Aussparung 9A am Steckplatz SA vorgesehen, die gemäß der linken Zeichnung von FIG 5 zwei vertikale Öffnungen 92 und 93 mit den Maßen A1 und A2 besitzt.

Das Anschlussmodul für den Steckplatz A besitzt demzufolge eine Gegenkontur bzw. einen klammerartigen Vorsprung 84A mit zwei abgewinkelten Schenkeln 841 und 842, deren vertikales Maß A1 - S bzw. A2 - S beträgt. Dabei entspricht S dem zum Einführen der Schenkel 841 und 842 in die frontalen Öffnungen 92 und 93 der Aussparung 9 bzw. 9A notwendigen Spiel. Durch die unterschiedlichen Abmessungen ist an der Befestigungseinrichtung für die Anschlussmodule am Installationsgerät 2 eine Kodierung geschaffen, um das Anstecken falscher Module zu vermeiden.

An folgendem Beispiel soll die Kodierung erläutert werden:

Steckplatz A:
Installationsgerät
   Maß A1 > A2
Anschlussmodul
   Maß A1-S > A2-S

Steckplatz B:
Installationsgerät
   Maß B1 > B2
Anschlussmodul
   Maß B1-S > B2-S
Unter folgenden Bedingungen kann dann eine Verwechslung vermieden werden:
   Maß A1 > B1,
   somit kann Modul A nicht in Steckplatz B gesteckt werden.
   Maß A2 < B2,
somit kann Modul B nicht in Steckplatz A gesteckt werden.

An dieser Stelle ist anzumerken, dass die L-förmige Aussparung 9 auch in dem Anschlussmodul 8 und die entsprechende Gegenkontur 84 in dem Installationsgerät 2 ausgebildet sein kann. Entsprechendes gilt auch für die folgende Kodierung.

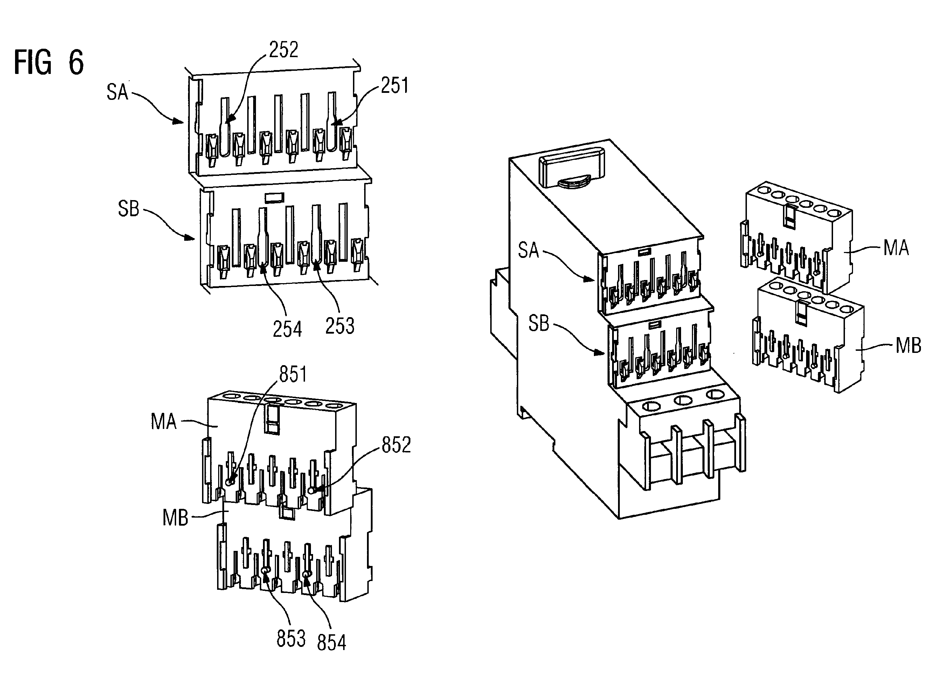

Eine zusätzliche Kodierungsmöglichkeit besteht darin, dass entsprechend FIG 6 an den beiden zu verbindenden Komponenten 2 und 8 Zapfen und entsprechende Aussparungen an bestimmten Orten oder in bestimmter Größe vorgesehen werden. So sind beispielsweise, wie dies in FIG 6 unten links dargestellt ist, für das Modul MA Zapfen 851 und 852 an anderen Stellen vorgesehen wie Zapfen 853 und 854 am Modul MB. Dies gilt sinngemäß für Gegenkodiermittel an den Steckplätzen SA und SB, die in FIG 6 links oben vergrößert dargestellt sind. Hier sind zu den Zapfen 851 bis 854 passenden Aussparungen 251 bis 254 vorgesehen, die längliche Gestalt besitzen, damit die Einführbewegung in Richtung W2 möglich bleibt.

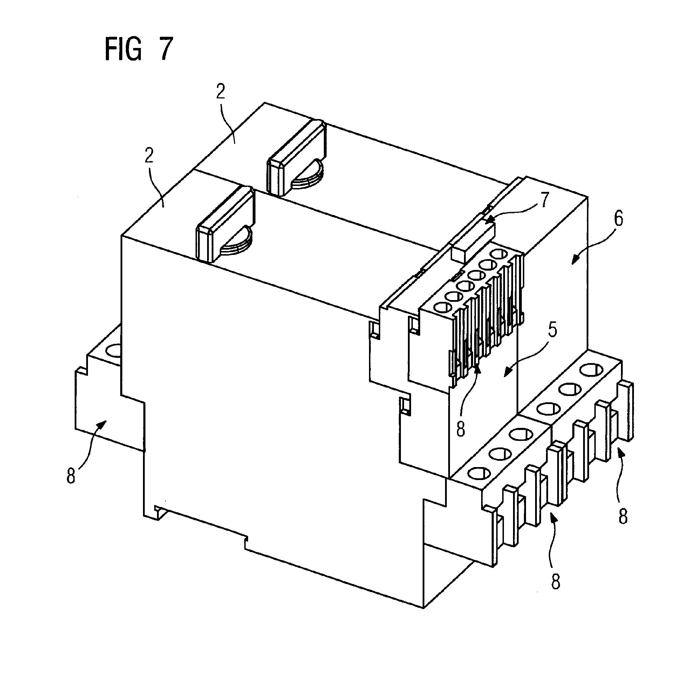

In FIG 7 ist ein Installationsgerät, z. B. ein Motorstarter, mit montierten Ansteuermodulen für eine Anbindung an ein Automatisierungssystem nach FIG 1 dargestellt. An die beiden kombinierten Installationsgeräte 2 sind neben den Anschlussmodulen 8 auch Ansteuermodule 5, 6 angesteckt. Insbesondere ist an eines der Installationsgeräte 2 ein Startmodul 5 und auf das andere ein Erweiterungsmodul 6 aufgesteckt. Diese beiden Ansteuermodule sind, wie bereits in FIG 1 angedeutet, mit einem Verbindungsstecker 7 gekoppelt. Da das Startmodul 5 Anschlüsse benötigt, ist auf das Startmodul 5 ein eigenes Anschlussmodul 8 gesteckt. Für diese Schnittstelle können die gleichen Befestigungs- und Kodiereinrichtungen verwendet werden wie für die Schnittstelle zwischen dem Startmodul 5 und dem Installationsgerät 2.

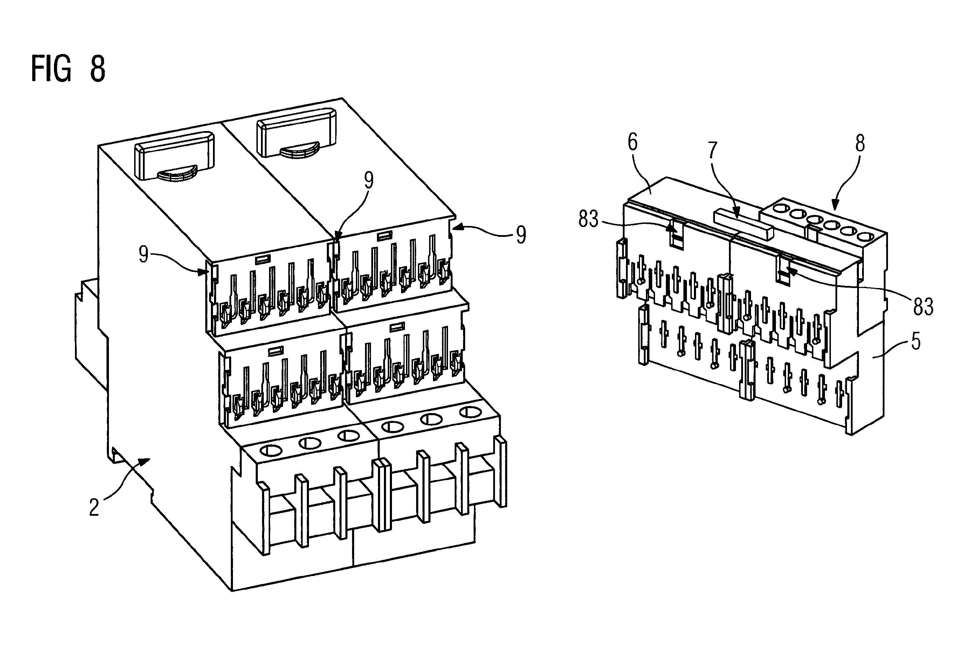

In FIG 8 ist ebenfalls die Installationsgerätekombination von FIG 7 dargestellt, wobei jedoch die Ansteuermodule 5 und 6 einschließlich des einen Anschlussmoduls 8 von den Installationsgeräten abgenommen wurden. In der grafischen Darstellung sind die abgenommenen Ansteuermodule 5, 6 gedreht dargestellt, so dass ihre Anschlussseite bzw. Modulschnittstelle sichtbar ist. Dementsprechend sind an den Installationsgeräten 2 beispielsweise die winkelförmigen Aussparungen 9 und an den Ansteuermodulen 5, 6 die Verrasthaken 83 deutlich zu erkennen.

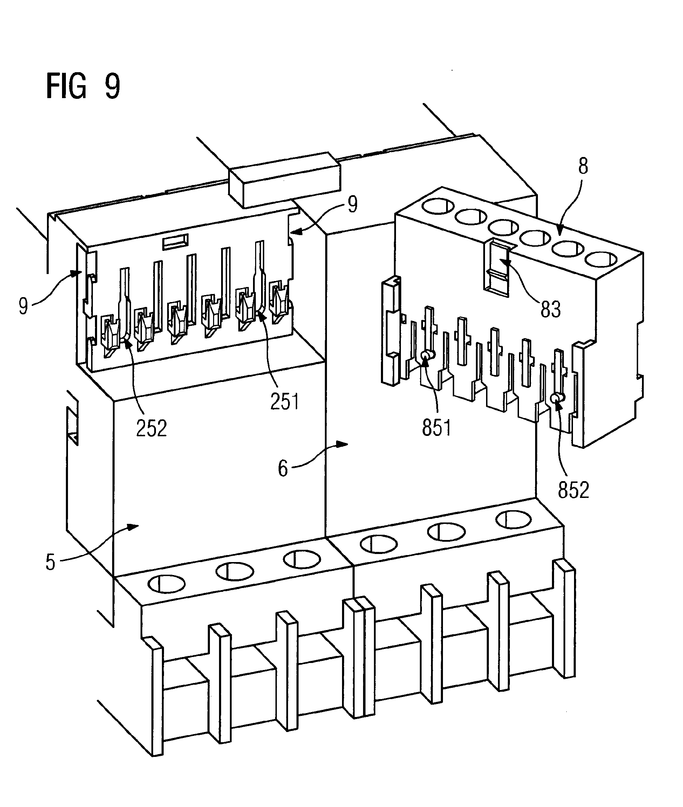

In FIG 9 sind die auf die Installationsgerätekombination von FIG 7 aufgesteckten Ansteuermodule 5 und 6 vergrößert dargestellt. Das Anschlussmodul 8 ist in dieser Figur abgenommen und gedreht wiedergegeben. Es besitzt, wie bereits erwähnt, die gleiche Anschlussschnittstelle wie die Ansteuermodule 5 und 6 oder die Anschlussmodule 81, 82 von FIG 3. Dementsprechend verfügt es über einen Verrasthaken 83 und über Zapfen 851 und 852 für die Zusatzkodierung.

An dem Modulsteckplatz für das Anschlussmodul 8 an dem Startmodul 5 sind dementsprechend die winkelförmigen Aussparungen 9 und die Aussparungen 251 und 252 zu erkennen. Auch in diesem Fall dienen die Aussparungen 9 nicht nur zur Befestigung, sondern erfindungsgemäß auch zur Kodierung.

Es liegt somit eine modulunabhängige Steckschnittstelle vor, die folgende Vorteile besitzt:
- Gleiches, durchgängiges Handling der Geräte durch den Benutzer sowohl bei der Montage als auch bei der Demontage ist gewährleistet.
- Die Kodierung und die Verriegelung sind über in die Gehäuseteile eingebrachte Konturen realisiert, d. h. es besteht kein zusätzlicher Aufwand bei der Herstellung durch zusätzliche Teile.
- Die geometrischen Abmessungen der modularen Anschlussblöcke und der Ansteuermodule können sehr gering gehalten werden.
- Die Ausführung der Kodierung und der Verrastung ist unabhängig von der Anschlusstechnologie.

## Patentansprüche

1. Installationsgerätekombination mit einem Installationsgerät (2), einem Zusatzmodul (5) zum Anbringen an das Installationsgerät (2) und einem weiteren Zusatzmodul (8), das an das Zusatzmodul (5) anbringbar ist , wobei das Zusatzmodul (5) umfasst:
- eine Geräteschnittstelle (SA, SB) einschließlich einer Befestigungseinrichtung (84), mit der das Zusatzmodul (5, 6) an das Installationsgerät (2) befestigbar ist,
- erste Kodiermittel (841, 842), die an der Geräteschnittstelle (SA, SB) angeordnet sind, so dass das Zusatzmodul (5, 6) nur dann an das Installationsgerät (2) anbringbar ist, wenn das Installationsgerät (2) entsprechende Gegenkodiermittel (92, 93) aufweist,
- wobei die ersten Kodiermittel (841, 842) Teil der Befestigungseinrichtung (84) sind und
- eine Modulschnittstelle (SA, SB) einschließlich einer Modulbefestigungseinrichtung (9), mit der das weitere Zusatzmodul (8) an das vorliegende Zusatzmodul (5) befestigbar ist, und Modulkodiermittel (92, 93), die an der Modulschnittstelle (SA, SB) angeordnet sind, besitzt, so dass das weitere Zusatzmodul (8) an dem vorliegenden Zusatzmodul (5) nur dann anbringbar ist, wenn das weitere Zusatzmodul (8) entsprechende Modulgegenkodiermittel (841, 842) aufweist,
**dadurch gekennzeichnet, dass**
- die Befestigungseinrichtung (84) mindestens einen, im Querschnitt L-förmigen Vorsprung (841, 842) aufweist, so dass das Zusatzmodul (5) durch zwei zueinander orthogonale Bewegungsvorgänge (W1, W2) an einer L-förmigen Aussparung (9) des Installationsgeräts (2) befestigbar ist, wobei entsprechend des ersten der Bewegungsvorgänge (W1) eine erste Fixierung erfolgt und über den zweiten der Bewegungsvorgänge (W2) das Zusatzmodul (5) in eine Endlage gebracht ist,
- die Modulbefestigungseinrichtung (9) mindestens eine L-förmige Aussparung (92, 93) aufweist, so dass ein im Querschnitt L-förmiger Vorsprung des weiteren Zusatzmoduls (8) durch zwei zueinander orthogonale Bewegungsvorgänge (W1, W2) an der L-förmigen Aussparung des vorliegenden Zusatzmoduls (5) befestigbar ist, wobei entsprechend des ersten der Bewegungsvorgänge (W1) eine erste Fixierung erfolgt und über den zweiten der Bewegungsvorgänge (W2) das weitere Zusatzmodul (8) in eine Endlage gebracht ist.

2. Installationsgerätekombination nach Anspruch 1, wobei das Zusatzmodul (5) als Anschlussmodul (8) oder Ansteuermodul (5, 6) ausgebildet ist.

3. Installationsgerätekombination nach Anspruch 1 oder 2, wobei das Zusatzmodul (5) eine Verriegelungseinrichtung zum Verriegeln des Zusatzmoduls an dem Installationsgerät (2) aufweist.

4. Installationsgerätekombination nach Anspruch 3, wobei die Verriegelungseinrichtung einen Verrasthaken (83) aufweist.

5. Installationsgerätekombination nach Anspruch 1 bis 4, wobei die Modulkodiermittel (92, 93) Teil der Modulbefestigungseinrichtung (9) sind.

6. Installationsgerätekombination nach einem der Ansprüche 1 bis 5, wobei zweite, von den ersten Modulkodiermitteln (92, 93) unabhängige Modulkodiermittel (251, 252) zum Zusammenwirken mit entsprechenden zweiten Modulgegenkodiermitteln (851, 852) an dem anzubringenden weiteren Zusatzmodul (8) an der Modulschnittstelle (SA, SB) angeordnet sind.

7. Installationsgerätekombination nach Anspruch 6, wobei die zweiten Modulkodiermittel (251, 252) mindestens einen Zapfen oder eine entsprechende Aussparung an einem vorgegebenen Ort an der Modulschnittstelle umfassen.

## Claims

1. Installation device combination with an installation device (2), an additional module (5) for attaching to the installation device (2) and a further additional module (8) which can be attached to the additional module (5), the additional module (5) comprising:
- a device interface (SA, SB) including a fixing device (84) with which the additional module (5, 6) can be fixed to the installation device (2),
- first coding means (841, 842) which are arranged at the device interface (SA, SB) so that the additional module (5, 6) can be attached to the installation device (2) only if the installation device (2) has corresponding counter-coding means (92, 93),
- the first coding means (841, 842) being part of the fixing device (84) and
- possessing a module interface (SA, SB) including a module fixing device (9) with which the further additional module (8) can be fixed to the existing additional module (5), and module coding means (92, 93) which are arranged at the module interface (SA, SB), so that the further additional module (8) can be attached to the existing additional module (5) only if the further additional module (8) has corresponding module counter-coding means (841, 842),
**characterised in that**
- the fixing device (84) has at least one projection (841, 842) which is L-shaped in cross-section, so that the additional module (5) can be fixed to an L-shaped recess (9) of the installation device (2) by two movement operations (W1, W2) which are orthogonal to one another, a first fixing being effected in accordance with the first of the movement operations (W1), and the additional module (5) being brought into a final position via the second of the movement operations (W2),
- the module fixing device (9) has at least one L-shaped recess (92, 93), so that a projection, which is L-shaped in cross-section, of the further additional module (8) can be fixed to the L-shaped recess of the existing additional module (5) by means of two movement operations (W1, W2) which are orthogonal to one another, a first fixing being effected in accordance with the first of the movement operations (W1), and the further additional module (5) being brought into a final position via the second of the movement operations (W2).

2. Installation device combination according to claim 1, the additional module (5) being embodied as a connection module (8) or control module (5, 6).

3. Installation device combination according to claim 1 or 2, the additional module (5) having a locking device for locking the additional module to the installation device (2).

4. Installation device combination according to claim 3, the locking device having a latching hook (83).

5. Installation device combination according to claims 1 to 4, the module coding means (92, 93) being part of the module fixing device (9).

6. Installation device combination according to one of claims 1 to 5, second module coding means (251, 252) independent of the first module coding means (92, 93) for interacting with corresponding second module counter-coding means (851, 852) on the further additional module (8) to be attached being arranged at the module interface (SA, SB).

7. Installation device combination according to claim 6, the second module coding means (251, 252) comprising at least one pin or a corresponding recess at a predefined location at the module interface.

## Revendications

1. Combinaison d'appareils d'installation, ayant un appareil (2) d'installation, un module (5) supplémentaire à mettre sur l'appareil (2) d'installation, et un autre module (8) supplémentaire qui peut être mis sur le module (5) supplémentaire, le module (5) supplémentaire comprenant :
- une interface (SA, SB) d'appareil, y compris un dispositif (84) de fixation, par lequel le module (5, 6) supplémentaire peut être fixé sur l'appareil (2) d'installation,
- des premiers moyens (841, 842) de codage, qui sont disposés sur l'interface (SA, SB) d'appareil, de manière à ne pouvoir mettre le module (5, 6) supplémentaire sur l'appareil (2) d'installation que si l'appareil (2) d'installation a des moyens (92, 93) antagonistes de codage correspondants,
- dans laquelle les premiers moyens (841, 842) de codage font partie du dispositif (84) de fixation et
- une interface (SA, SB) de module, y compris un dispositif (9) de fixation de module, par lequel l'autre module (8) supplémentaire peut être fixé au module (5) supplémentaire présent, et des moyens (92, 93) de codage de module, qui sont disposés sur l'interface (SA, SB) de module, de manière à ce que le module (8) supplémentaire ne puisse être mis sur le module (5) supplémentaire présent que si l'autre module (8) supplémentaire a des moyens (841, 842) antagonistes de codage de module correspondants
**caractérisé en ce que**
- le dispositif (84) de fixation a au moins une saillie (841, 842) de section transversale en forme de L, de manière à pouvoir fixer le module (5) supplémentaire par deux opérations (W1, W2) de déplacement orthogonales entre elles, sur un évidement (9) en forme de L de l'appareil (2) d'installation, une première immobilisation s'effectuant conformément à la première des opérations (W1) de déplacement et le module (5) supplémentaire étant mis dans la position définitive par la deuxième des opérations (W2) de déplacement,
- le dispositif (9) de fixation de module a au moins un évidement (92, 93) en forme de L, de manière à pouvoir fixer une saillie en forme de L en section transversale de l'autre module (8) supplémentaire par deux opérations (W1, W2) de déplacement orthogonales entre elles sur l'évidement en forme de L du module (5) supplémentaire présent, une première immobilisation s'effectuant conformément à la première des opérations (W1) de déplacement, et l'autre module (8) supplémentaire étant mis dans une position définitive par la deuxième des opérations (W2) de déplacement.

2. Combinaison d'appareil d'installation suivant la revendication 1, dans laquelle le module (5) supplémentaire est constitué en module (8) de raccordement ou en module (5, 6) de commande.

3. Combinaison d'appareil d'installation suivant la revendication 1 ou 2, dans laquelle le module (5) supplémentaire a un dispositif de verrouillage pour verrouiller le module supplémentaire sur l'appareil (2) d'installation.

4. Combinaison d'appareil d'installation suivant la revendication 3, dans laquelle le dispositif de verrouillage a un crochet (83) de verrouillage.

5. Combinaison d'appareil d'installation suivant l'une des revendications 1 à 4, dans laquelle les moyens (92, 93) de codage de module font partie du dispositif (9) de fixation de module.

6. Combinaison d'appareil d'installation suivant l'une des revendications 1 à 5, dans laquelle des deuxièmes moyens (251, 252) de codage de module, indépendants des premiers moyens (92, 93) de codage de module, sont disposés sur l'interface (SA, SB) de module, pour coopérer avec des deuxièmes moyens (851, 852) de codage antagonistes de module sur l'autre module (8) supplémentaire à mettre.

7. Combinaison d'appareil d'installation suivant la revendication 6, dans laquelle les deuxièmes moyens (251, 252) de codage de module comprennent au moins un tourillon ou un évidement correspondant en un emplacement déterminé à l'avance de l'interface de module.
